(19) Europäisches Patentamt
European Patent Office
Office européen des brevets

(11) **EP 1 796 452 A1**

(12) **EUROPÄISCHE PATENTANMELDUNG**

(43) Veröffentlichungstag:
**13.06.2007 Patentblatt 2007/24**

(51) Int Cl.:
**H05K 13/04** *(2006.01)*

(21) Anmeldenummer: 06125082.5

(22) Anmeldetag: **30.11.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **06.12.2005 DE 102005058282**

(71) Anmelder: **SIEMENS AKTIENGESELLSCHAFT
80333 München (DE)**

(72) Erfinder:
• **Andersch, Walter
85551 Kirchheim (DE)**
• **Burger, Stefan
81379 München (DE)**

(54) **Bestückkopf zum Bestücken von Substraten mit elektrischen Bauteilen**

(57) Ein Bestückkopf (1) zum Bestücken von Substraten mit elektrischen Bauteilen (4) umfasst einen Grundkörper (2), zumindest eine Greifereinheit (3) zum Halten der Bauteile (4), welche drehbar am Grundkörper (2) angeordnet ist, einen Drehantrieb (5) zum Drehen der Greifereinheit (3), mit einem ersten Antriebskörper (8) und einem zweiten Antriebskörper (10), welcher eine Aussparung (9) aufweist, die den ersten Antriebskörper (8) zumindest teilweise aufnimmt, wobei einer der Antriebskörper (8, 10) relativ zu dem anderen der Antriebskörper (8, 10) bewegbar ist und einander zugewandte Mantelflächen (11) der Antriebskörper (8, 10) derart zusammenwirken, dass die Bewegung des einen Antriebskörpers (8, 10) eine Drehung des anderen Antriebskörpers (8, 10) bewirkt und wobei die Greifereinheit (3) mit dem anderen Antriebskörper (8, 10) drehfest gekoppelt ist.

FIG 2

EP 1 796 452 A1

**Beschreibung**

Die Erfindung betrifft einen Bestückkopf zum Bestücken von Substraten mit elektrischen Bauteilen, mit einer Greifereinheit zum Halten der Bauteile und einem Drehantrieb, mittels welchem ein Drehen der Greifereinheit in sehr kleinen und genauen Winkelschritten möglich ist.

In der Bestücktechnik werden Substrate von einem Bestückkopf eines Bestückautomaten mit elektrischen Bauteilen bestückt. Der Bestückkopf weist in der Regel eine oder mehrere Greifereinheiten auf, welche die Bauteile aufnehmen, halten und absetzen. Um die Bauteile vor dem Absetzen in eine gewünschte Winkellage zu drehen, sind die Greifereinheiten drehbar gelagert. Da die Genauigkeitsanforderungen an die Drehpositionierung der Bauteile sehr hoch sind, müssen die dafür verwendeten Drehantriebe eine sehr hohe Winkelauflösung ermöglichen. Bei den bisher bekannten Bestückköpfen wird dies entweder mit Servomotoren oder mit Zahnraduntersetzungen realisiert. Die Ausrüstung des Bestückkopfes mit Servomotoren ist sehr kostspielig, wogegen die komplizierten Zahnraduntersetzungen störanfällig und bauraumtechnisch aufwändig sind.

Aus der Offenlegungsschrift DE-4435996 A1 ist ein Drehantrieb mit einem in einem Gehäuse auf einer Welle drehfest gelagerten Rotor bekannt. Zur Erzeugung einer Drehbewegung des Rotors ist ein den Rotor umgreifendes Gehäuseteil relativ zu dem Rotor bewegbar.

Weiterhin ist aus der Patentschrift JP 11-220295 A ein Bestückkopf gemäß dem Oberbegriff des Anspruchs 1 bekannt. Dabei erfolgt die Übertragung des Drehmoments auf die Saugpipette berührungslos mittels einer magnetischen Kopplung.

Es ist die Aufgabe der vorliegenden Erfindung, einen Bestückkopf mit einem alternativen Drehantriebskonzept zu liefern, mit welchem eine präzise Drehpositionierung der Bauteile möglich ist.

Diese Aufgabe wird durch den erfindungsgemäßen Bestückkopf gemäß dem unabhängigen Anspruch 1 gelöst. Vorteilhafte Ausgestaltungen des Bestückkopfes sind Gegenstand der Unteransprüche.

Der Bestückkopf gemäß dem unabhängigen Anspruch 1 weist einen Grundkörper und zumindest eine Greifereinheit zum Halten der Bauteile auf, welche drehbar am Grundkörper angeordnet ist. Der Bestückkopf umfasst ferner einen Drehantrieb zum Drehen der Greifereinheit, mit einem ersten Antriebskörper und einem zweiten Antriebskörper, welcher eine Aussparung aufweist, die den ersten Antriebskörper zumindest teilweise aufnimmt. Einer der Antriebskörper ist relativ zu dem anderen der Antriebskörper bewegbar, wobei einander zugewandte Mantelflächen der Antriebskörper derart zusammenwirken, dass die Bewegung des einen Antriebskörpers eine Drehung des anderen Antriebskörpers bewirkt. Mittels eines Federelements ist der eine Antriebskörper derart mit dem Grundkörper gekoppelt, dass es eine Taumelbewegung des einen Antriebskörpers ermöglicht, eine Drehung des einen Antriebskörpers um seine Längsachse jedoch verhindert. Auf diese Weise wird die Relativbewegung der beiden Antriebskörper auf einfache und kostengünstige Weise erreicht. Die Greifereinheit ist dabei mit dem anderen Antriebskörper drehfest gekoppelt und wird bei dessen Bewegung mitgedreht. Der Aufbau eines derartigen Drehantriebs weist sich durch eine geringe Anzahl von Einzelbauteilen aus, welche einfach als kostengünstige Dreh- oder Stanzteile herzustellen sind. Ferner sind bei geeigneter Dimensionierung der Antriebskörper sehr hohe Untersetzungsverhältnisse darstellbar. Durch die Einfachheit der Konstruktion erweist sich der Bestückkopf als sehr zuverlässig.

Bei einer Ausgestaltung des Bestückkopfes gemäß Anspruch 2 weist dieser einen Schrittmotor auf, mittels welchem der eine Antriebskörper des Drehantriebs bewegbar ist. Schrittmotoren sind im Vergleich zu Servomotoren sehr günstig in der Anschaffung und bieten den Vorteil eines erheblich geringeren Steuerungsaufwands. Trotz Verwendung des preisgünstigen Schrittmotors ist aufgrund des verwendeten Drehantriebs eine sehr hohe Winkelauflösung für die Drehpositionierung von an der Greifereinheit gehaltenen Bauteilen möglich.

Bei einer Ausgestaltung des Bestückkopfes nach Anspruch 3 weisen die Antriebskörper ferromagnetisches Material auf und an einem der Antriebskörper sind Magnetelemente derart angeordnet, dass Teile der einander zugewandten Mantelflächen der Antriebskörper durch die Magnetkraft gegeneinander gepresst werden. Bei dieser Ausgestaltung des Bestückkopfes erfolgt die Drehmomentübertragung zwischen den Antriebskörpern mittels Reibschluss. Durch die magnetische Anziehung der Reibflächen der Antriebskörper kann das übertragbare maximale Drehmoment erheblich gesteigert werden, ohne dass dabei z. B. Zahnräder verwendet werden. Im Vergleich zur formschlüssigen Drehmomentübertragung mittels Zahnräder erweist sich diese Ausgestaltung als kostengünstiger und auch betriebssicherer, da keine Getriebezähne abbrechen können. Ferner ist der Drehantrieb überlast- und blockiersicher.

In einer Ausgestaltung nach Anspruch 4 ist das Federelement derart ausgebildet, dass Teile der einander zugewandten Mantelflächen der Antriebskörper durch die Federkraft gegeneinander gepresst werden. Durch die Anpresskraft kann die zwischen den Antriebskörpern herrschende Reibkraft und damit das zu übertragende maximale Drehmoment deutlich gesteigert werden. Durch die doppelte Funktion des Federelements kann die Anzahl der Einzelbauteile weiter gering gehalten werden.

Im Folgenden wird ein Ausführungsbeispiel des erfindungsgemäßen Bestückkopfes mit Bezug auf die beigefügten Figuren näher erläutert. In den Figuren sind:

Figur 1 eine schematische Darstellung eines Ausführungsbeispiels des erfindungsgemäßen Bestückkopfes;

Figuren 2 und 3 schematische Prinzip-Darstellungen des Drehantriebs zum Drehen der Greifereinheit;

Figur 4 bis Figur 6 verschiedene Ausführungsbeispiele des Drehantriebs des Bestückkopfes.

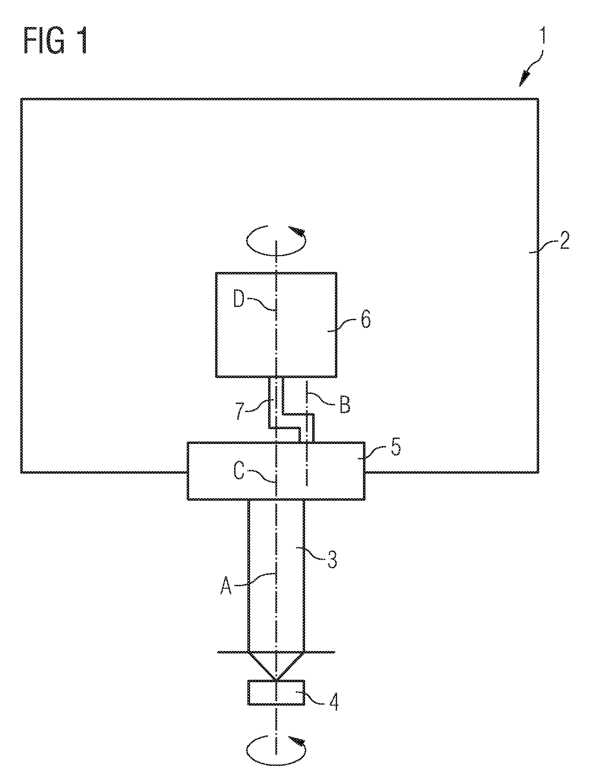

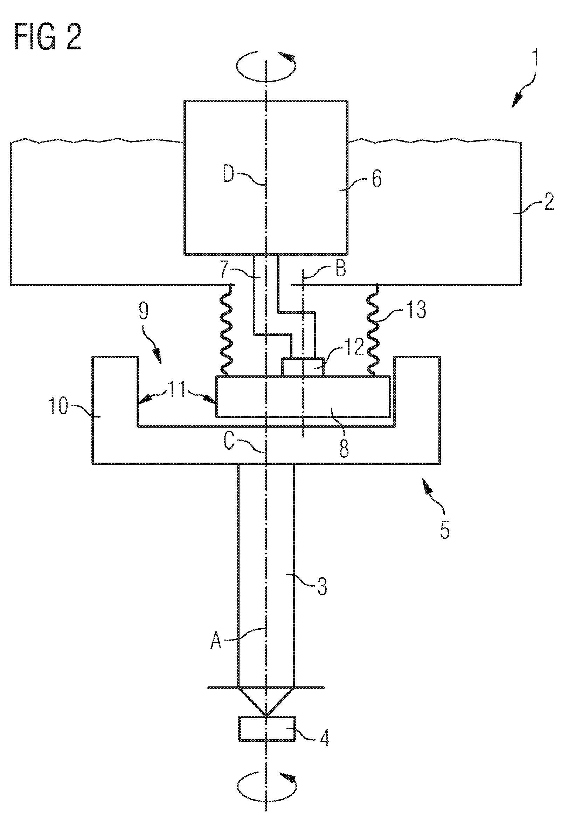

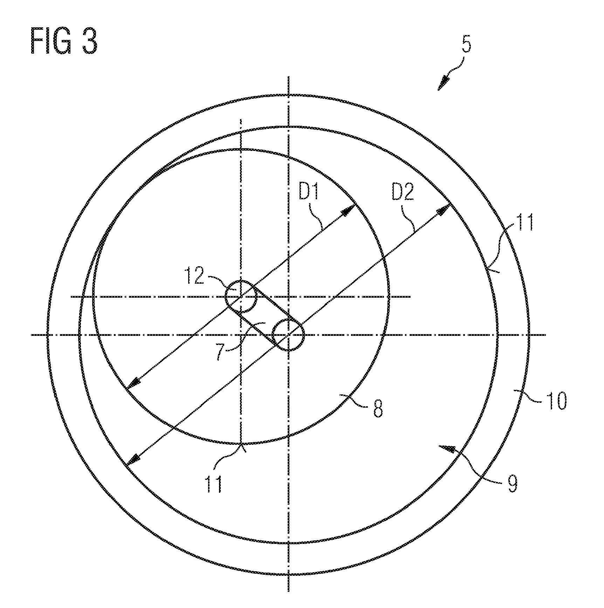

In Figur 1 ist ein Ausführungsbeispiel des erfindungsgemäßen Bestückkopfes 1 schematisch dargestellt. Der Bestückkopf 1 weist einen Grundkörper 2 auf, an welchem zumindest eine Greifereinheit 3 zum Halten elektrischer Bauteile 4 angeordnet ist. Die zylindrische Greifereinheit 3 ist dabei relativ zum Grundkörper 2 des Bestückkopfes 1 um ihre Längsachse A drehbar gelagert. Die Greifereinheit 3 ist mit einem in Figur 1 sehr schematisch dargestellten Drehantrieb 5 gekoppelt, mittels welchem die Greifereinheit 3 in sehr kleinen Winkelschritten bzw. hoher Winkelauflösung gedreht werden kann. Auf den genauen Aufbau des Drehantriebs 5 wird später noch eingegangen. Der Bestückkopf 1 umfasst ferner einen Motor 6, welcher über eine Exzenterwelle 7 mit dem Drehantrieb 5 gekoppelt ist. Bei dem Motor 6 handelt es sich vorzugsweise um einen kostengünstigen Schrittmotor, welcher sich durch einen sehr geringen Steuerungsaufwand ausweist. Der genaue Wirkzusammenhang zwischen dem Motor 6, dem Drehantrieb 5 und der Greifereinheit 3 wird im Folgenden mit Bezug auf die Figuren 2 und 3 näher erläutert.

Die Figuren 2 und 3 sind schematische Prinzipskizzen, anhand welcher das Funktionsprinzip des Drehantriebs 5 für die Greifereinheiten 3 näher erläutert wird. Der Drehantrieb 5 zum Drehen der Greifereinheit 3 umfasst allgemein zwei Antriebskörper 8, 10, welche in Wechselwirkung miteinander stehen und derart ausgebildet und relativ zueinander angeordnet sind, dass eine Drehung der Greifereinheit 3 mit einem sehr hohen Übersetzungsverhältnis erzielbar ist. Im Ausführungsbeispiel der Figuren 2 und 3 ist ein erster Antriebskörper 8 als rad- bzw. zylinderförmige Scheibe ausgebildet, welche in einer Aussparung eines trommel- bzw. hohlzylinderförmigen zweiten Antriebskörpers 10 aufgenommen ist. Der Durchmesser D1 des ersten Antriebskörpers 8 ist kleiner ausgebildet als der Innendurchmesser D2 der Aussparung 9 des zweiten Antriebskörpers 10. Die Mittelachse B des ersten Antriebskörpers 8 und die Mittelachse C des zweiten Antriebskörpers 10 sind dabei derart versetzt zueinander angeordnet, dass Teile einander zugewandter Mantelflächen 11 des ersten und zweiten Antriebskörpers 8, 10 in Reibkontakt stehen.

Wie bezüglich der Figur 1 schon erwähnt wurde, ist der Motor 6 und der erste Antriebskörper 8 über die Exzenterwelle 7 miteinander verbunden. Der Motor 6 ist dabei so angeordnet, dass seine Drehachse D mit der Mittelachse C des zweiten Antriebskörpers 10 zusammenfällt. Die Greifereinheit 3 ist drehfest mit dem zweiten Antriebskörper 10 verbunden, wobei deren Längsachse A mit der Mittelachse C des zweiten Antriebskörpers 10 zusammenfällt. Somit sind die Drehachse D des Motors 6, die Längsachse A der Greifereinheit 3 und die Mittelachse C des zweiten Antriebskörpers 10 identisch.

Die Exzenterwelle 7 ist an einem Ende mit dem ersten Antriebskörper 8 in dessen Mittelpunkt über ein Wälz- bzw. Kugellager 12 gekoppelt. Gleichzeitig ist der erste Antriebskörper 8 jedoch in geeigneter Weise, im Ausführungsbeispiel der Figur 2 mittels eines Federelements 13 bzw. eines Federbalgs, drehfest mit dem Grundkörper 2 des Bestückkopfes 1 verbunden. Der Federbalg 13 lässt gleichzeitig eine seitliche Auslenkung des ersten Antriebskörpers 8 relativ zu dem zweiten Antriebskörper 10 zu, verhindert jedoch eine Drehung des ersten Antriebskörpers 8 um seine Mittelachse B. Aus der Zusammenschau der Figuren 2 und 3 wird deutlich, dass bei Betrieb des Motors 6 der erste Antriebskörper 8 relativ zu dem zweiten Antriebskörper 10 eine Taumelbewegung innerhalb der Aussparung des zweiten Antriebskörpers 10 vollführt. Aufgrund der Tatsache, dass sich der erste Antriebskörper 8 um seine Mittelachse B nicht dreht und Teile der einander zugewandten Mantelflächen 11 des ersten und zweiten Antriebskörpers 8, 10 in reibschlüssigem Kontakt zueinander stehen, kommt es zu einer Drehmomentübertragung zwischen dem ersten und dem zweiten Antriebskörper 8, 10 derart, dass sich der zweite Antriebskörper 10 zusammen mit der Greifereinheit 3 um seine Mittelachse C dreht. Das dabei geltende Untersetzungsverhältnis i ergibt sich dabei aus folgender Gleichung:

$$i = \frac{D2}{(D2 - D1)}$$

Daraus folgt, dass das Untersetzungsverhältnis i umso größer ist, je kleiner der Unterschied bzw. die Differenz zwischen dem Innendurchmesser D2 der Aussparung 9 des zweiten Antriebskörpers 10 und dem Durchmesser D1 des ersten Antriebskörpers 8 ist. Somit lässt sich allein durch die Dimensionierung der Antriebskörper 8, 10 stufenlos ein beliebiges Untersetzungsverhältnis i, insbesondere besonders sehr große Untersetzungsverhältnisse i, darstellen. Es ist anzumerken, dass in Fig. 3 der Unterschied zwischen den Durchmessern D1 und D2 aus Gründen der besseren Übersichtlichkeit sehr groß ist.

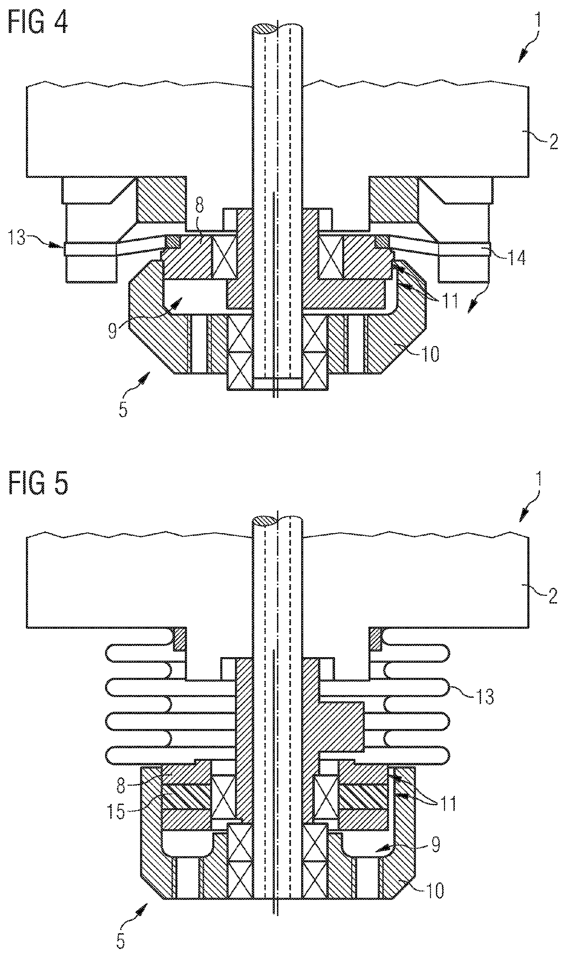

Anhand der Figuren 4, 5 und 6 werden weitere vorteilhafte Ausgestaltungen des Drehantriebs 5 erläutert. Aus Gründen der besseren Übersichtlichkeit wurde in diesen Figuren auf die Darstellung des Motors 6, der Exzenterwelle 7 und der Greifereinheit 3 verzichtet. Dagegen wurden nur die zur Erläuterung des Drehantriebs 5 unbedingt notwendigen Bestandteile dargestellt.

In Figur 4 weist der erste Antriebskörper 8 einen nach unten zulaufenden, konischen Querschnitt auf. Das Federelement 13 besteht aus einer Mehrzahl gebogener Einzelfedern 14, welche spiralförmig am Außenumfang des ersten Antriebskörpers 8 anliegen. Die Einzelfedern 14 verhindern eine Drehung des ersten Antriebskörpers 8 um seine Mittelachse B, erlauben jedoch die oben näher erläuterte Taumelbewegung des ersten Antriebskörpers 8 innerhalb der Aussparung des zweiten Antriebskörpers 10. Die Einzelfedern 14 sind derart ausgebildet, dass sie den ersten Antriebskörper 8 gegen den zweiten Antriebskörper 10 (in Figur 4 nach unten) vorspannen. Somit werden die einander zugewandten Mantelflächen 11 des ersten und zweiten Antriebskörpers 8, 10 an ihrer Kontaktstelle durch die Federkraft gegeneinander gepresst. Die dadurch gesteigerte Flächenpressung bewirkt eine Erhöhung des Reibschlusses und des zu übertragenden maximalen Drehmoments.

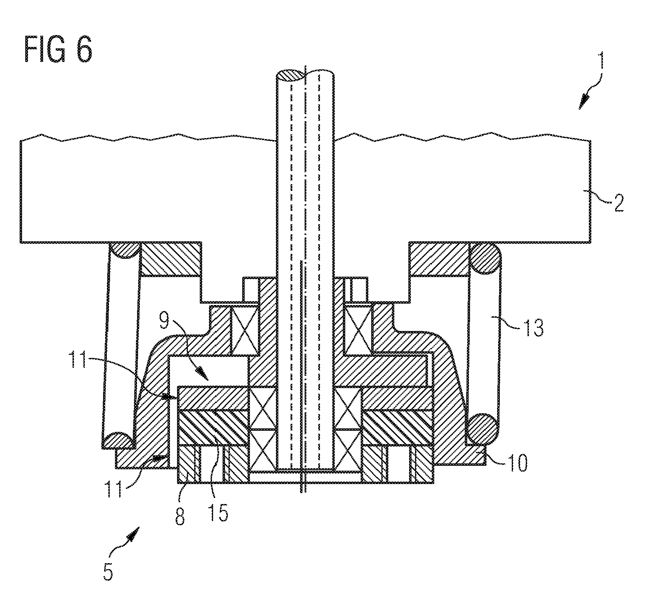

In der Ausgestaltung der Figur 5 ist das Federelement 13, wie schon anhand der Figur 2 beschrieben, als Federbalg 13 ausgebildet. Sowohl der erste Antriebskörper 8 als auch der zweite Antriebskörper 10 weisen ferromagnetisches Material auf. An seiner äußeren Mantelfläche 11 weist der erste Antriebskörper 8 Magnetelemente 15 auf, so dass die einander zugewandten Mantelflächen 11 des ersten und zweiten Antriebskörpers 8, 10 an ihrer Kontaktstelle durch die anziehende Magnetkraft gegeneinander gepresst werden. Auch auf diese Weise ergibt sich eine erhöhte Flächenpressung, wodurch der Reibschluss und das zu übertragende maximale Drehmoment spürbar erhöht werden können.

Der in Figur 6 dargestellte Drehantrieb 5 funktioniert prinzipiell wie die schon vorher beschriebenen Ausführungsformen. Im Unterschied dazu weist der zweite Antriebskörper 10 einen glocken- oder hohlzylinderförmigen Querschnitt auf, in dessen Aussparung 9 der rad- bzw. zylinderförmige erste Antriebskörper 8 aufgenommen ist. In diesem Fall weist der erste Antriebskörper 8 an seinem Außenumfang die Magnetelemente 15 auf, so dass ein besserer Reibschluss zwischen den beiden Antriebskörpern 8, 10 erreicht wird. Während in den Ausgestaltungen der Figuren 4 und 5 der erste Antriebskörper 8 von dem zweiten Antriebskörper 10 außen umfasst wird und innerhalb der Aussparung 9 die Taumelbewegung durchführt, umgreift der erste Antriebskörper 8 in der Ausgestaltung gemäß Figur 6 den zweiten Antriebskörper 10 und vollführt die Taumelbewegung entlang der äußeren Umfangsfläche des zweiten Antriebskörpers 10.

Der oben dargestellte Bestückkopf 1 zeichnet sich durch eine kostengünstige und kompakte Bauweise aus. Insbesondere der Drehantrieb 5 für die Greifereinheiten 3 ermöglicht beliebige Übersetzungsverhältnisse zwischen dem Motor 6 und den zu drehenden Greifereinheiten 3. Die Einzelelemente des Drehantriebs 5 lassen sich kostengünstig herstellen und die Struktur des Drehantriebs 5 erfordert im Vergleich zu Zahnradgetrieben einen sehr geringen Bauraum. Da zwischen den beiden Antriebskörpern 8, 10 eine reibschlüssige Verbindung besteht, weist sich der Drehantrieb 5 als sehr zuverlässig und im Vergleich zu Zahnradgetrieben überlast- und blockiersicher aus. Selbst bei einem Verschleiß der Umfangsflächen der Antriebskörper 8, 10 bleiben die beiden Antriebskörper 8, 10 gegeneinander verspannt und spielfrei. Lediglich eine geringe Änderung des Übersetzungsverhältnisses ist die Folge, welche jedoch über eine regelmäßige Kalibrierung korrigiert werden kann.

Bezugszeichenliste:

1 Bestückkopf
2 Grundkörper
3 Greifereinheit
4 Elektrisches Bauteil
5 Drehantrieb
6 Motor
7 Exzenterwelle
8 Erster Antriebskörper
9 Aussparung
10 Zweiter Antriebskörper
11 Mantelflächen
12 Lager
13 Federelement
14 Einzelfeder
15 Magnetelement

**Patentansprüche**

1. Bestückkopf (1) zum Bestücken von Substraten mit elektrischen Bauteilen (4), mit

   - einem Grundkörper (2),
   - zumindest einer Greifereinheit (3) zum Halten der Bauteile (4), welche drehbar am Grundkörper (2) angeordnet ist,
   - einem Drehantrieb (5) zum Drehen der Greifereinheit (3), mit einem ersten Antriebskörper (8) und einem zweiten Antriebskörper (10), welcher eine Aussparung (9) aufweist, die den ersten Antriebskörper (8) zumindest teilweise aufnimmt, wobei einer der Antriebskörper (8, 10) relativ zu dem anderen der Antriebskörper (8, 10) bewegbar ist und einander zugewandte Mantelflächen (11) der Antriebskörper (8, 10) derart zusammenwirken, dass die Bewegung des einen Antriebskörpers (8, 10) eine Drehung des anderen Antriebskörpers (8, 10) bewirkt und wobei die Greifereinheit (3) mit dem anderen Antriebskörper (8, 10) drehfest gekoppelt ist,

   **dadurch gekennzeichnet,**
   **dass** der eine Antriebskörper (8, 10) mittels eines Federelements (13) mit dem Grundkörper (2) gekoppelt ist, wobei das Federelement (13) derart ausgebildet ist, dass es eine Taumelbewegung des einen Antriebskörpers (8, 10) ermöglicht, eine Drehung dieses einen Antriebkörpers (8, 10) jedoch verhindert.

2. Bestückkopf (1) nach Anspruch 1, mit einem Schrittmotor (6), mittels welchem der eine Antriebskörpers (8, 10) bewegbar ist.

3. Bestückkopf (1) nach einem der Ansprüche 1 bis 2, wobei die Antriebskörper (8, 10) ferromagnetisches Material aufweisen und an einem der Antriebskörper (8, 10) Magnetelemente (15) derart angeordnet sind, dass Teile der einander zugewandten Mantelflächen (11) der Antriebskörper (8, 10) durch die Magnetkraft gegeneinander gepresst werden.

4. Bestückkopf (1) nach einem der Ansprüche 1 bis 3, wobei das Federelement (13) derart ausgebildet ist, dass die einander zugewandten Mantelflächen (11) durch die Federkraft gegeneinander gepresst wer-den.

FIG 1

FIG 2

## FIG 3

FIG 4

FIG 5

FIG 6

**Europäisches Patentamt**

**EUROPÄISCHER RECHERCHENBERICHT**

Nummer der Anmeldung

EP 06 12 5082

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y,D | JP 11 220295 A (MATSUSHITA ELECTRIC IND CO LTD) 10. August 1999 (1999-08-10) * Seite 3, Absatz 10-12; Abbildungen 1-3,5 * ----- | 1-4 | INV. H05K13/04 |
| Y,D | DE 44 35 996 A1 (BOSCH GMBH ROBERT [DE]) 11. April 1996 (1996-04-11) * Spalte 2, Zeile 21 - Spalte 4, Zeile 67; Abbildungen 1,2 * ----- | 1,4 | |
| Y | EP 0 277 731 A (DYNAPERT PRECIMA LTD [GB]; EMHART IND [US]) 10. August 1988 (1988-08-10) * Spalte 13, Zeile 48 - Spalte 14, Zeile 47 * ----- | 2 | |
| Y | DE 39 38 088 A1 (BOSCH GMBH ROBERT [DE]) 23. Mai 1991 (1991-05-23) * das ganze Dokument * ----- | 3 | |
| A | DE 103 05 370 A1 (SIEMENS AG [DE]) 26. August 2004 (2004-08-26) * das ganze Dokument * ----- | 1 | RECHERCHIERTE SACHGEBIETE (IPC) |
| A | US 5 068 565 A (HUANG DAXU [CN]) 26. November 1991 (1991-11-26) * das ganze Dokument * ----- | 1,4 | H05K H02K H01L |

Der vorliegende Recherchenbericht wurde für alle Patentansprüche erstellt

| Recherchenort | Abschlußdatum der Recherche | Prüfer |
|---|---|---|
| München | 30. März 2007 | Debre, Angela |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 06 12 5082

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-03-2007

| Im Recherchenbericht angeführtes Patentdokument | | Datum der Veröffentlichung | Mitglied(er) der Patentfamilie | | Datum der Veröffentlichung |
|---|---|---|---|---|---|
| JP 11220295 | A | 10-08-1999 | KEINE | | |
| DE 4435996 | A1 | 11-04-1996 | KEINE | | |
| EP 0277731 | A | 10-08-1988 | JP US | 63196100 A 4898507 A | 15-08-1988 06-02-1990 |
| DE 3938088 | A1 | 23-05-1991 | CH | 681264 A5 | 15-02-1993 |
| DE 10305370 | A1 | 26-08-2004 | KEINE | | |
| US 5068565 | A | 26-11-1991 | CN | 1044700 A | 15-08-1990 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4435996 A1
- JP 11220295 A